(19) Europäisches Patentamt
European Patent Office
Office européen des brevets

(11) **EP 3 499 247 B1**

(12) **EUROPÄISCHE PATENTSCHRIFT**

(45) Veröffentlichungstag und Bekanntmachung des Hinweises auf die Patenterteilung:
**26.02.2020   Patentblatt 2020/09**

(51) Int Cl.:
***G01R 15/18*** *(2006.01)*      ***H01F 27/40*** *(2006.01)*
***H01F 19/08*** *(2006.01)*

(21) Anmeldenummer: **18020617.9**

(22) Anmeldetag: **26.11.2018**

(54) **GALVANISCH GETRENNTE SCHNITTSTELLE UND VERFAHREN ZUR ÜBERTRAGUNG ANALOGER SIGNALE ÜBER DIESE SCHNITTSTELLE**

GALVANICALLY SEPARATE INTERFACE AND METHOD FOR TRANSMITTING ANALOGUE SIGNALS THROUGH THIS INTERFACE

INTERFACE ISOLÉE GALVANIQUEMENT ET PROCÉDÉ DE TRANSMISSION DE SIGNAUX ANALOGIQUES PAR L'INTERMÉDIAIRE DE LADITE INTERFACE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.12.2017   DE 102017011681**

(43) Veröffentlichungstag der Anmeldung:
**19.06.2019   Patentblatt 2019/25**

(73) Patentinhaber: **WILO SE**
**44263 Dortmund (DE)**

(72) Erfinder:
• **Brosius, Sascha**
**44263 Dortmund (DE)**
• **Blöcker, Gerrit**
**44263 Dortmund (DE)**
• **Sanders, Tilman Philip**
**44263 Dortmund (DE)**

(74) Vertreter: **Cohausz Hannig Borkowski Wißgott**
**Patentanwaltskanzlei GbR**
**Schumannstraße 97-99**
**40237 Düsseldorf (DE)**

(56) Entgegenhaltungen:
**DE-A1- 10 057 315     DE-A1-102005 007 378**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine elektrische Schnittstelle mit galvanischer Trennung für ein Pumpenaggregat sowie ein Verfahren zur galvanisch getrennten Übertragung analoger Signale über diese Schnittstelle.

In vielen Fällen werden bei Geräten elektrische Schnittstellen benötigt, um externe Steuer- und/ oder Messsignale einer Geräteelektronik zuzuführen. Häufig verwendet man hierzu standardisierte Signale, wie z.B. ein analoges 0-10 Spannungssignal, ein analoges 4-20mA Stromsignal oder ein pulsweitenmoduliertes (PWM) Signal, welches in Art und Form ein digitales Rechtecksignal ist. Derartige Signale werden beispielsweise von Steuergeräten verwendet, um ein anderes Gerät anzusteuern. Das Signal bildet dann ein Steuersignal und repräsentiert steuerungstechnisch meist einen Sollwert. Aber auch Messgeräte verwenden oft die genannten standardisierten Signale, welche dann entsprechend Messsignale bilden, welche von der Geräteelektronik verarbeitet werden.

Zum Schutz beider Geräte wird gefordert, dass die Schnittstelle eine galvanische Trennung besitzt, so dass sich eine elektrische Störung, insbesondere ein Kurzschluss, auf der einen Seite der Schnittstelle nicht auf die andere Seite auswirkt. Zur galvanischen Trennung werden in der Praxis Transformatoren oder Optokoppler eingesetzt. Während das PWM-Signal ein Wechselsignal ist, handelt es sich bei dem analogen Spannungs- und Stromsignal um ein abschnittsweise konstantes Signal, d.h. um ein Gleichsignal, weshalb diese nach dem Stand der Technik vor der Übertragung über die galvanische Trennung hinweg vorverarbeitet, insbesondere digitalisiert und in ein Wechselsignal umgewandelt werden.

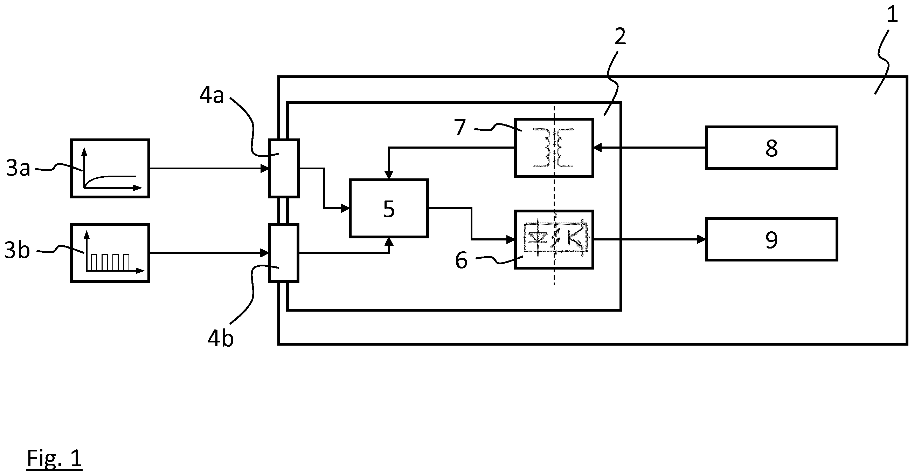

Ein Beispiel für eine bekannte Schnittstelle 2 zeigt Figur 1. Zur galvanischen Trennung der Signalübertragung wird hier ein Optokoppler 6 verwendet, dessen Ausgangssignal an die Elektronik 9 geleitet wird. Die Vorverarbeitung erfolgt mittels eines Mikrocontrollers 5, der wiederum an den Schnittstelleneingang 4a, 4b angeschlossen ist. Im Falle der Figur 1 ist ein erster Schnittstelleneingang 4a für analoge Eingangssignale und ein zweiter Schnittstelleneingang 4b für digitale Signal vorgesehen. Diese sind mit zwei entsprechenden Eingängen am Mikrocontroller 5 verbunden. Da die Vorverarbeitung bzw. der Mikrocontroller 5 eine Spannungsversorgung benötigt, ist eine zweite galvanische Trennung erforderlich, die hier in Gestalt eines Transformators 7 erfolgt. Dieser erhält eine Spannung aus einer Spannungsversorgung 8.

In Summe benötigen die beiden galvanischen Trennungen und die Vorverarbeitung entsprechenden Bauraum. Zudem sind die elektrischen Schnittstellen nach dem Stand der Technik vergleichsweise komplex und in der Herstellung teuer.

DE10 2005 007378 offenbart eine Vorrichtung zur induktiven Erfassung eines Gleichstroms. Zentral steht ein Transformator, dessen zweite Wicklung mit einem "Abfragesignal" beaufschlagt wird, wobei dann über einen festen Messwiderstand, nach Gleichrichtung, Verstärkung und Komparierung eine Entscheidung (zum Schalten) getroffen wird. Ziel ist, hier eine Temperaturabhängigkeit der Permeabilität des Ferrits des Trafokerns über eine Temperaturabhängige Veränderung des beaufschlagenden Abfragesignals zu kompensieren. Es ist daher Aufgabe der vorliegenden Erfindung, eine elektrische Schnittstelle zur galvanisch getrennten Übertragung analoger sowie gleichzeitig auch digitaler Signale bereitzustellen, die gegenüber dem Stand der Technik konstruktiv einfacher ausgestaltet ist und weniger Bauraum in Anspruch nimmt. Insbesondere soll sie nur eine einzige galvanische Trennung umfassen. Entsprechend ist es Aufgabe der Erfindung, ein Verfahren zur Übertragung analoger Eingangssignale über diese Schnittstelle zur Verfügung zu stellen.

Diese Aufgabe wird durch eine Schnittstelle mit den Merkmalen des Anspruchs 1 sowie ein Verfahren mit den Merkmalen des Anspruchs 13 gelöst. Vorteilhafte Weiterbildungen sind in den jeweiligen Unteransprüchen angegeben.

Erfindungsgemäß wird eine elektrische Schnittstelle für ein Pumpenaggregat zur galvanisch getrennten Übertragung eines analogen Eingangssignals zu einer Elektronik vorgeschlagen, umfassend einen Schnittstelleneingang, einen Transformator mit einer ersten und einer zweiten Wicklung und einer Messschaltung, wobei die beiden Wicklungen in einem magnetischen Kreis miteinander gekoppelt sind, die erste Wicklung mit dem Schnittstelleneingang zum Anlegen eines analogen Eingangssignals verbunden ist und die zweite Wicklung mit der Messschaltung verbunden ist. Die Messschaltung umfasst eine änderbare Widerstandsbeschaltung, mit der die zweite Wicklung beschaltet ist. Ferner ist die Messschaltung dazu eingerichtet, die zweite Wicklung durch die Änderung der Widerstandsbeschaltung mit einer wechselnden Spannung zu beaufschlagen, aus dem zeitlichen Verlauf zumindest einer elektrischen Größe der Widerstandsbeschaltung eine Zeitspanne zu bestimmen und daraus die Höhe des Eingangssignals zu ermitteln.

Ein Kernaspekt der Erfindung ist es somit, die Übertragung eines analogen Eingangssignals über einen Transformator vorzunehmen, wobei das Eingangssignal an die erste Wicklung des Transformators angelegt wird und eine magnetische Durchflutung innerhalb des Kerns des Transformators und damit eine Änderung seiner Permeabilität bewirkt wird. Die hierdurch wiederum entstehende Induktivitätsänderung wird anhand des zeitlichen Verlauf einer elektrischen Größe der Messschaltung ausgewertet.

Die erfindungsgemäße Schnittstelle ist für ein Pumpenaggregat vorgesehen. Die Erfindung betrifft somit auch ein Pumpenaggregat, die eine erfindungsgemäße Schnittstelle aufweist. Das Pumpenaggregat kann bevorzugt ein Kreiselpumpenaggregat sein.

Die erfindungsgemäße Schnittstelle ermöglicht die galvanisch getrennte Übertragung von analogen Eingangssignalen wie beispielsweise einem 0-10V Steuer- oder Messsignal von dem Schnittstelleneingang zu einer Elektronik des Pumpenaggregats unter Verwendung einer einzigen galvanischen Trennung, die hier in Gestalt des Transformators realisiert ist. Die Schnittstelle besitzt somit kein weiteres Bauteil, um den Schnittstelleneingang galvanisch von der Pumpenelektronik zu trennen. Des Weiteren ist auch keine DC-AC -Wandlung des Eingangssignals vor der ersten Wicklung erforderlich, so dass die Schnittstelle insgesamt einen geringen Bauraum hat.

Die erfindungsgemäße Schnittstelle und das in ihr implementierte Verfahren ermöglichen die galvanisch getrennte Übertragung analoger Signale, die abschnittsweise konstant sind, d.h. Gleichgrößen. Diese ändern sich über einen längeren Zeitraum, z.B. Sekunden, Minuten oder Stunden nicht. Derartige Signale können nicht ohne Weiteres über einen Transformator übertragen werden, da in diesem, um auf der Ausgangswicklung eine Spannung induzieren zu können, ein wechselnder Fluss erforderlich ist, der von der Eingangswicklung erzeugt werden muss. Ein konstantes Signal erzeugt jedoch nur einen konstanten Fluss. Daher kann ein Transformator nur Gleichgrößen übertragen.

Um dieses Problem zu lösen, wird die zweite Wicklung erfindungsgemäß von der Messschaltung durch Änderung der Widerstandsbeschaltung, mit welcher die zweite Wicklung beschaltet ist, mit einer wechselnden Spannung beaufschlagt. Hierdurch erzeugt die zweite Wicklung im Transformatorkern einen wechselnden magnetischen Grundfluss. Der vom Eingangssignal erzeugte, konstante magnetische Fluss überlagert sich mit dem Grundfluss und beeinflusst dadurch die Induktivität des Transformators, welche wiederum die Zeitkonstante bestimmt, mit der sich die elektrischen Größen der Widerstandsbeschaltung, d.h. auf der Seite der zweiten Wicklung ändern. Ein Aspekt des erfindungsgemäßen Verfahrens ist es, aus diesem durch die Zeitkonstante bestimmten, zeitlich-charakteristischen Verlauf zumindest einer elektrischen Größe der Widerstandsbeschaltung die Höhe des Eingangssignals zu ermitteln.

Idealerweise handelt es sich bei dem Transformatorkern um einen weichmagnetischen Werkstoff. Dies hat den Vorteil, dass die Remanenz und die Hysterese nahe null sind.

Damit das Eingangssignal nicht verfälscht wird, sollte der wechselnde Grundfluss nur einen Bruchteil des von der ersten Wicklung erzeugten konstanten Flusses betragen, beispielsweise weniger als 20% dieses Flusses, insbesondere ca. 10%. Dies kann beispielsweise durch ein geeignetes Verhältnis der Windungsanzahlen der ersten Wicklung zur zweiten Wicklung erreicht werden. Vorzugsweise beträgt das Windungszahlenverhältnis zwischen 1:10 bis 1:20. Je größer das Windungsverhältnis ist, desto genauer ist die Messung. Bei der ersten Wicklung ist eine Maximalgrenze der Windungsanzahl durch die räumlichen Verhältnisse gegeben. Diese Maximalgrenze ist somit abhängig von der Größe des Kerns. Beispielsweise kann die erste Wicklung 120 Windungen aufweisen. Seitens der zweiten Wicklung ist eine Untergrenze für die Windungszahl zu beachten. Wird die Anzahl der Windungen der zweiten Wicklung verringert, wird der Einfluss der Hysterese größer und hat negativen Einfluss auf die Messung. Untersuchungen haben gezeigt, dass beispielsweise 7 Windungen bei der zweiten Wicklung zu guten Ergebnissen führen.

Gemäß einer Ausführungsvariante kann die Änderung der Widerstandsbeschaltung periodisch sein. Dies bedeutet, dass die Spannung, mit der die zweite Wicklung beaufschlagt wird, mit einer bestimmten Frequenz wechselt. Beispielsweise kann diese Frequenz zwischen 1kHz und 20kHz, vorzugsweise bei 8kHz liegen. Somit können die Frequenzen verwendet werden, die häufig in Motorsteuerungen von Pumpenaggregaten verwendet werden.

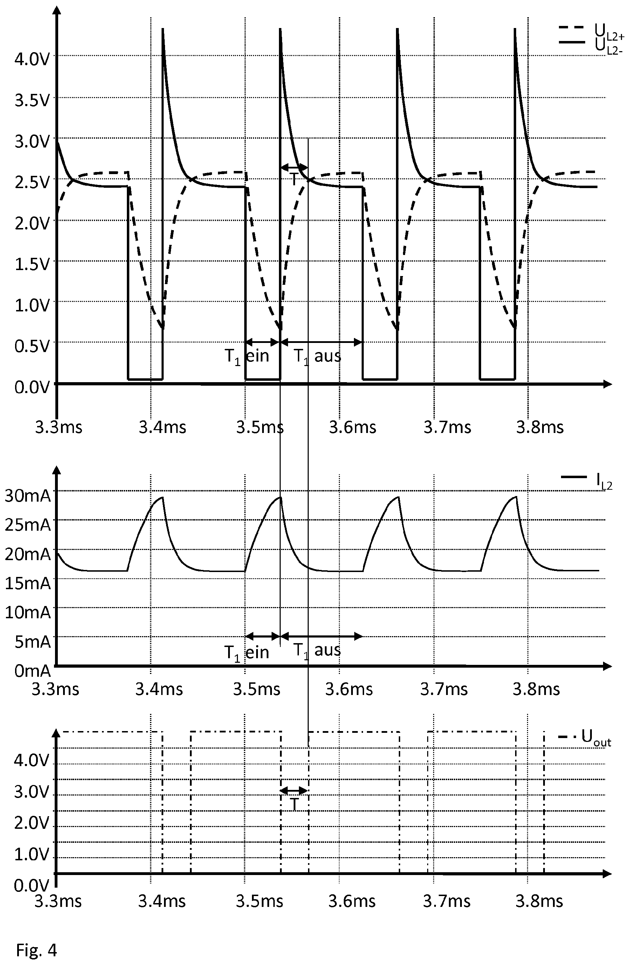

Von besonderem Vorteil ist es, wenn die erste und die zweite Wicklung mit gleichem Wicklungssinn gewickelt sind. Dies bedeutet, dass bei einem positiven Stromfluss durch die jeweilige Wicklung jeweils ein positiver magnetischer Fluss erzeugt wird und dass diese Flüsse in dieselbe Richtung gerichtet sind. Somit ist gewährleistet, dass der wechselnde Grundfluss durch den vom Eingangssignal erzeugten konstanten Fluss nur erhöht, d.h. nicht verringert wird. Somit wird die Permeabilitätskurve $\mu$=f(H) in einem Bereich verwendet, siehe Fig. 4 in dem die Abhängigkeit der Permeabilität vom Fluss eindeutig ist.

Gemäß einer Ausführungsvariante bildet die Widerstandsbeschaltung einen Spannungsteiler, wobei die zweite Wicklung in einem ersten Zweig des Spannungsteilers liegt. Vorzugsweise ist sie in Reihe mit zumindest einem Widerstand geschaltet. Beispielsweise kann es sich dabei um einen Widerstand handeln, der die zweite Wicklung zu einer Versorgungsspannung oder zu Masse hin verbindet. Alternativ oder zusätzlich kann in dem ersten Zweig ein Serienwiderstand liegen, mit dem die zweite Wicklung in Reihe geschaltet ist. Ist jedoch der Innenwiderstand der zweiten Wicklung groß genug, kann auf diesen Serienwiederstand auch verzichtet werden.

Zur Erzeugung der wechselnden Spannung kann vorgesehen sein, dass der elektrisch wirksame Widerstandswert eines Zweiges des Spannungsteilers änderbar ist. Das bedeutet, dass die wechselnde Spannung an der Wicklung dadurch bewirkt wird, dass der tatsächlich wirkende elektrische Widerstand der Beschaltung abwechselnd geändert wird. Dies kann auf vielfältige Art geschehen, beispielsweise indem ein oder mehrere Widerstände in der Widerstandsbeschaltung hinzugenommen oder weggeschaltet werden.

Gemäß einer Ausführungsvariante umfasst die Widerstandsbeschaltung zwei Widerstände, wobei die zweite Wicklung wahlweise mit einem oder zwei der Widerstände in Reihe zwischen eine Versorgungsspannung und Masse schaltbar ist. Entsprechend ist die Messschaltung dazu eingerichtet, die zweite Wicklung abwechselnd mit einem oder zwei der Widerstände in Reihe zwischen die Versorgungsspannung und Masse zu schalten. Beispielsweise kann der erste Zweig über einen ersten Widerstand mit der Versorgungsspannung verbunden oder verbindbar sein und über einen zweiten Widerstand mit Masse verbunden oder verbindbar sein. Somit liegt der erste Zweig zwischen dem ersten und dem zweiten Widerstand und umfasst nur die zweite Wicklung. Eine solche Schaltung ist sinnvoll, wenn der Innenwiderstand der zweiten Wicklung ausreichend groß ist, beispielsweise mindestens einige Ohm ist.

Gemäß einer Ausführungsvariante umfasst die Widerstandsbeschaltung zumindest drei Widerstände, wobei die zweite Wicklung wahlweise mit zwei oder drei der Widerstände in Reihe zwischen eine Versorgungsspannung und Masse schaltbar ist. Entsprechend ist die Messschaltung dazu eingerichtet, die zweite Wicklung abwechselnd mit zwei oder drei der Widerstände in Reihe zwischen die Versorgungsspannung und Masse zu schalten. Beispielsweise kann der erste Zweig über einen ersten Widerstand mit der Versorgungsspannung verbunden oder verbindbar sein und über einen zweiten Widerstand mit Masse verbunden oder verbindbar sein. Somit liegt der erste Zweig zwischen dem ersten und dem zweiten Widerstand und umfasst einen dritten Widerstand in Reihe mit der zweiten Wicklung. Eine solche Schaltung ist sinnvoll, wenn der Innenwiderstand der zweiten Wicklung klein ist, insbesondere kleiner als ein Ohm ist.

Beispielsweise kann der erste und der zweite Widerstand gleich groß sein. Sie können zum Beispiel im Bereich 10Ω bis 1kΩ liegen. Demgegenüber kann der dritte Widerstand kleiner sein. Vorzugsweise kann sein Wert ein Zehntel oder weniger des Werts des ersten oder zweiten Widerstands betragen.

Die Widerstandsbeschaltung kann beispielsweise einen steuerbaren Schalter, insbesondere einen steuerbaren Halbleiterschalter aufweisen, um die Widerstandsbeschaltung zustandsabhängig zu ändern. Dabei kann es sich vorzugsweise um einen Transistor, insbesondere einen Bipolartransistor oder einen MOSFET Transistor handeln. Geeigneterweise liegt dieser Schalter parallel oder in Reihe mit einem Widerstand der Widerstandsbeschaltung. Im Falle eines parallel liegenden Schalters überbrückt dieser den Widerstand in seinem geschlossenen Zustand, so dass die Wirkung dieses Widerstands aufgehoben ist. Im geöffneten Zustand des Schalters wirkt der Widerstand dagegen. Im Falle eines in Reihe liegenden Schalters wirkt der Widerstand demgegenüber nur im geschlossenen Zustand des Schalters, während er im geöffneten Zustand des Schalters nicht wirkt. Durch das Öffnen und Schließen des Schalters ändern sich die Spannungsverhältnisse in der Widerstandsbeschaltung und damit auch an der zweiten Wicklung schlagartig. Die Spannungen zeigen einen exponentiell ansteigenden oder fallenden Verlauf, der jeweils gegen einen stationären Wert konvergiert. Dieser Verlauf ist durch die Zeitkonstante $\tau$ charakterisiert, welche wiederum durch den aktuellen Wert der Induktivität $L_2$ der zweiten Wicklung und durch den aktuell wirksamen Widerstand R definiert ist, $\tau = L_2/R$.

Eine besonders einfache, änderbare Widerstandsbeschaltung wird erreicht, wenn der erste Zweig über den Schalter mit Masse verbindbar ist. Alternativ kann der erste Zweig über den Schalter mit einer Versorgungsspannung verbindbar sein.

Vorzugsweise ist die Messschaltung eingerichtet, den Schalter abwechselnd ein und aus zu schalten, insbesondere ihn mit einer Frequenz zwischen 1kHz und 20kHz, vorzugsweise mit etwa 8kHz anzusteuern. Somit wird auch die Widerstandsbeschaltung periodisch mit dieser Frequenz geändert, und die an der zweiten Wicklung wirkende Spannung wechselt mit der Frequenz des Ansteuersignals des Schalters.

Dabei ist es nicht erforderlich, dass das Taktverhältnis eins ist, d.h. das Verhältnis der zeitlichen Dauer des eingeschalteten zum ausgeschalteten Zustand des Schalters gleich ist. Vielmehr können diese zeitlichen Dauern unterschiedlich sein. Vorzugsweise ist das Taktverhältnis so gewählt, dass die zeitliche Dauer desjenigen Zustands des Schalters, bei dem die zweite Wicklung mit weniger Widerständen in Reihe liegt, kürzer ist, als die zeitliche Dauer desjenigen Zustands des Schalters, bei dem die zweite Wicklung mit mehr Widerständen in Reihe liegt. Dies trägt dem Umstand Rechnung, dass bei einer größeren Anzahl an Widerständen in Reihe mit der zweiten Wicklung der wirksame Gesamtwiderstand höher ist und dadurch die zweite Wicklung langsamer geladen wird. Deshalb dauert es in diesem Fall länger, bis der stationäre Zustand erreicht ist. Allerdings muss dieser Zustand nicht unbedingt erreicht werden. Vielmehr kann der Schalter vor Erreichen dieses Zustands geschaltet werden. Gemäß einer bevorzugten Ausführungsvariante ist deshalb das Taktverhältnis so gewählt, dass die zeitliche Dauer des Einschaltzustands des Schalters kürzer ist, als die zeitliche Dauer des Ausschaltzustands.

Gemäß einer Ausführungsvariante ist die zumindest eine elektrische Größe der Widerstandsbeschaltung, die verwendet wird, um die Höhe des Eingangssignals zu ermitteln, die Spannung an der zweiten Wicklung, insbesondere an dem ersten Zweig.

Zur Bestimmung der Zeitspanne kann die Messschaltung eine Signalauswerteeinheit umfassen, die parallel zu dem ersten Zweig liegt. Hierdurch steht der Signalauswerteeinheit die Spannung am ersten Zweig bzw. an der Wicklung zur Verfügung, um diese auszuwerten.

Dabei kann die Signalauswerteeinheit einen Vergleicher zum Vergleichen des Potenzials am Eingangsknoten des ersten Zweiges mit dem Potential am Ausgangsknoten des ersten Zweiges aufweisen. Dabei ist der Eingangsknoten derjenige Knoten der Widerstandsbeschaltung, in den ein positiver Strom in den ersten Zweig hineinfließt, und der Ausgangsknoten derjenige Knoten der Widerstandsbeschaltung, aus dem ein positiver Strom aus dem ersten Zweig herausfließt. Dies ermöglicht, eine qualitative Aussage der Spannung am Eingangsknoten in Bezug zur Spannung am Ausgangsknoten treffen zu können. Die Spannung am Ausgangsknoten dient somit als Referenzspannung. Es kann jedoch auch die Spannung am Eingangsknoten als Referenzspannung dienen.

Beispielsweise kann der Vergleicher ein Komparator sein. Durch diesen Komparator wird ein Ausgangssignal erhalten, das angibt, ob die Spannung am Eingangsknoten größer oder kleiner als die Spannung am Ausgangsknoten ist. Beispielsweise kann das Ausgangssignal des Komparators null sein bzw. auf Masse liegen, wenn die Spannung am Eingangsknoten kleiner ist, als die Spannung am Ausgangsknoten. Entsprechend kann das Ausgangssignal des Komparators auf logisch eins (Potenzial der Versorgungsspannung V1) sein, wenn die Spannung am Eingangsknoten größer ist, als die Spannung am Ausgangsknoten.

Alternativ kann der Vergleicher derart eingerichtet sein, ein Ausgangssignal zu erzeugen, das je nach Verhältnis der Spannung am Eingangsknoten zur Spannung am Ausgangsknoten größer oder kleiner null ist. Hierzu kann der Vergleicher in der Art eines Differenzierers arbeiten, d.h. die Differenz aus der Spannung am Eingangsknoten und der Spannung am Ausgangsknoten wird gebildet und deren Vorzeichen am Ausgang des Vergleichers ausgegeben.

Alternativ kann der Vergleicher derart eingerichtet sein, ein Ausgangssignal zu erzeugen, das je nach Verhältnis der Spannung am Eingangsknoten zur Spannung am Ausgangsknoten größer oder kleiner eins ist. Hierzu kann der Vergleicher in der Art eines Dividierers, arbeiten, d.h. dass das Verhältnis aus der Spannung am Eingangsknoten und der Spannung am Ausgangsknoten wird gebildet und deren Verhältnis am Ausgang des Vergleichers ausgegeben.

Der Vergleicher kann ein diskretes, eigenständiges elektronisches Bauteil sein, oder als ein Funktionsbaustein Teil eines größeren Elektronikbausteins mit mehreren Funktionseinheiten sein, wie beispielsweise einem Mikroprozessor oder einem Mikrocontroller. In diesem kann der Vergleicher ausschließlich in Hardware ausgebildet sein. Er kann in diesem alternativ aber auch teilweise oder vollständig durch Software realisiert sein.

Gemäß einer Ausführungsvariante kann die Signalauswerteeinheit einen Zeitgeber umfassen, der dazu eingerichtet ist, bei einem ersten Wechsel des Ausgangssignals des Vergleichers einen Zähler zu starten und bei einem zweiten Wechsel des Ausgangssignals des Vergleichers den Zähler zu stoppen. Der Zählerwert, der beim Stoppen des Zählers vorliegt, beschreibt dann die bestimmte Zeitspanne. Somit bildet der Zeitgeber, englisch Timer genannt, eine Art Stoppuhr.

Der Zeitgeber kann ebenfalls ein diskretes, eigenständiges elektronisches Bauteil sein, zum Beispiel durch einen Integrator gebildet sein. In dieser Ausführungsvariante ist der Zeitgeber dem Vergleicher elektrisch nachgeschaltet, so dass der Ausgang des Vergleichers mit dem Eingang des Zeitgebers verbunden ist. Er kann alternativ als ein Funktionsbaustein Teil eines größeren Elektronikbausteins mit mehreren Funktionseinheiten sein, wie beispielsweise einem DSP, einem Mikroprozessor oder einem Mikrocontroller. In diesem kann der Zeitgeber ausschließlich in Hardware ausgebildet sein. Er kann in diesem alternativ aber auch durch Software realisiert sein. Sind der Vergleicher und der Zeitgeber beide Funktionseinheiten des größeren Elektronikbausteins, ist der Zeitgeber funktional dem Vergleicher nachgeordnet.

Gemäß einer Ausführungsvariante kann die Signalauswerteeinheit einen Zuordner umfassen, der dazu eingerichtet ist, aus der abgeleiteten Zeitspanne die Höhe des Eingangssignals zu ermitteln. Hierzu ist der Ausgang des Zeitgebers elektrisch oder zumindest funktional mit dem Eingang des Zuordners verbunden, so dass ihm die ermittelte Zeitspanne T zugeführt wird. Dieser wird dann vom Zuordner ein bestimmter Wert der Eingangsgröße zugeordnet. Dies kann im Rahmen der Auswertung eines funktionalen, insbesondere mathematischen Zusammenhangs $U_E = f(T)$ oder im Rahmen einer tabellarischen Zuordnung erfolgen, die im Zuordner hinterlegt sein kann bzw. ist. Dabei kann der Zusammenhang zwischen der Zeitspanne T und dem Eingangssignal $U_E$ werksseitig ermittelt worden sein und in der Signalauswertung abgespeichert sein. Der Zuordner gibt dann an seinem Ausgang einen dem Wert des Eingangssignals $U_E$ entsprechenden Wert aus, welcher der Elektronik zur weiteren Verarbeitung zugeleitet werden kann bzw. wird.

Der Zuordner kann ebenfalls ein diskretes, eigenständiges elektronisches, insbesondere programmierbares Bauteil wie ein FPGA, DSP, ein Mikroprozessor, oder ein Mikrocontroller sein, wobei die vom Zuordner durchzuführende Zuordnung vorzugsweise softwaretechnisch realisiert ist. Somit besteht der Zuordner teilweise aus Software, teilweise aus Hardware. Der Zuordner kann einen Speicher zu Speicherung des Zusammenhangs zwischen der Zeitspanne T und dem Eingangssignal $U_E$ umfassen. Dieser kann Teil des programmierbaren Bauteils oder ein zu diesem extern angeordneter und verbundener Speicherbaustein sein, beispielsweise eine EEPROM.

Gemäß einer bevorzugten Ausführungsvariante ist die Signalauswerteeinheit ein Mikrocontroller, in welchem der Vergleicher, der Zähler und/ oder der Zuordner als eine, insbesondere jeweils eine Funktionseinheit bilden, insbesondere implementiert sind. Somit sind der Vergleicher, der Zähler und/ oder der Zuordner gemeinsam in einem größeren Elektronikbaustein, dem Mikrocontroller, untergebracht. Der Verschaltungsaufwand ist dadurch minimal und Signalverarbeitung zwischen Vergleicher, Zähler und Zuordner ist besonders einfach zu gestalten.

Vorzugsweise ist Signalauswerteeinheit auch dazu eingerichtet, das Steuersignal für den Schalter zu erzeugen. Dies kann beispielsweise durch einen Frequenzgenerator erfolgen, der ebenfalls Teil der Signalauswerteeinheit, insbesondere Teil des Mikrocontrollers sein kann.

Gemäß einem Aspekt der Erfindung ist das Pumpenaggregat, in dem die erfindungsgemäße Schnittstelle vorhanden ist, zum Beispiel ein Kreiselpumpenaggregat, wie sie beispielsweise für Heizungs- oder Kälteanlagen oder in der Trinkwasserversorgung zum Einsatz kommen. Derartige Kreiselpumpenaggregate bestehen aus einer elektromotorischen Antriebseinheit, einer von diesem angetriebenen Pumpeneinheit und einer Motorelektronik, die den Motor ansteuert und die Pumpe vorzugsweise regelt. Die erfindungsgemäße Schnittstelle kann Teil dieser Motorelektronik sein, die aufgrund ihrer die Pumpe regelnden oder steuernden Funktion auch Pumpenelektronik genannt wird. Die Motorelektronik oder Pumpenelektronik kann baulich mit dem Motor eine Einheit bilden. Sie kann aber alternativ auch nur auf diesen montierbar sein oder für eine Anordnung extern zum Motor vorgesehen sein, z.B. für eine Wandmontage. Eine bauliche Verbindung zwischen der Motorelektronik bzw. Pumpenelektronik und dem Rest des Pumpenaggregats ist somit nicht erforderlich. Das Pumpenaggregat, in dem die erfindungsgemäße Schnittstelle vorhanden ist, kann auch durch ein Pumpensystem gebildet sein, das zwei oder mehr funktional zusammenwirkende Kreiselpumpenaggregate umfasst. Diese können von einer gemeinsamen Motorelektronik bzw. Pumpenelektronik angesteuert werden, die separat zu den Motoren der Kreiselpumpenaggregate, insbesondere zentral aufgestellt sein kann, so dass auch hier keine bauliche Verbindung zu den Motoreinheiten vorhanden sein muss.

Entsprechend der vorbeschriebenen Schnittstelle, umfasst die vorliegende Erfindung gemäß einem Aspekt auch ein Verfahren zur galvanisch getrennten Übertragung eines analogen Eingangssignals über eine derartige Schnittstelle zu einer Elektronik, wobei die Schnittstelle einen Transformator mit einer ersten und einer in einem magnetischen Kreis mit der ersten gekoppelten zweiten Wicklung aufweist, und das Verfahren die folgenden Schritte umfasst:

- Beaufschlagung der ersten Wicklung mit dem Eingangssignal
- Beaufschlagen der zweiten Wicklung mit einer wechselnden Spannung durch periodisches Ändern einer Widerstandsbeschaltung einer Messschaltung, die mit der zweiten Wicklung verbunden ist,
- Bestimmung einer Zeitspanne aus dem zeitlichen Verlauf zumindest einer elektrischen Größe der Widerstandsbeschaltung
- Ermittlung der Höhe des Eingangssignals aus der Zeitspanne.

Vorzugsweise erfolgt die Änderung periodisch, so dass auch die wechselnde Spannung eine periodische Wechselspannung ist. Dies vereinfacht die Bestimmung der Zeitspanne.

Beispielsweise wird die wechselnde Spannung dadurch erzeugt, dass die zweite Wicklung abwechselnd mit zwei oder drei Widerständen zwischen eine Versorgungsspannung und Masse geschaltet wird.

Die Bestimmung der Zeitspanne erfolgt vorzugsweise aus der Spannung an einem ersten Zweig der Widerstandsbeschaltung, der die zweite Wicklung oder eine Reihenschaltung aus der zweiten Wicklung und einem Serienwiderstand umfasst. Diese Spannung bildet die vorgenannte elektrische Größe.

Die Bestimmung der Zeitspanne kann beispielsweise mittels eines Vergleichers insbesondere eines Komparators erfolgen, der parallel zu dem ersten Zweig liegt und dessen Ausgangsignal wechselt, wenn die Spannung am ersten Zweig ihr Vorzeichen wechselt. Die zu bestimmende Zeitspanne ist dabei der zwischen zwei aufeinander folgenden Vorzeichenwechsel liegende Zeitraum.

Hierbei wird vorteilhafterweise der Effekt ausgenutzt, dass sich mit dem Ändern der Widerstandsbeschaltung die an der zweiten Wicklung wirkende Spannung in ihrem Vorzeichen abrupt ändert, nämlich negativ wird und erst dann allmählich in Richtung des stationären Zustands strebt, der jedoch eine positive Spannung ist. Insoweit bekommt die Selbstinduktionsspannung einen erneuten Vorzeichenwechsel, der vom Vergleicher festgestellt werden kann und der zu einem bestimmten Zeitpunkt stattfindet, der durch die aktuell wirkende Induktivität der zweiten Wicklung und durch den aktuell wirkenden Gesamtwiderstand der Widerstandsbeschaltung bestimmt ist. Mit anderen Worten ändert sich dieser Zeitpunkt in Abhängigkeit der wirkenden Induktivität. Da hier ein linearer Zusammenhang besteht, wird der Zeitpunkt durch eine Erhöhung der Induktivität zeitlich nach hinten geschoben und durch eine Verringerung der Induktivität zeitlich nach vorne geschoben. Da die Induktivität wiederum linear mit der Permeabilität zusammenhängt, gilt dasselbe für den Zusammenhang des Zeitpunktes mit der Permeabilität.

Da die Permeabilität wiederum von der Höhe des Eingangssignals abhängt, besteht auch ein Zusammenhang zwischen dem Eingangssignal und dem Zeitpunkt, und zwar derart, dass ein erhöhtes Eingangssignal den Zeitpunkt nach vorne verschiebt und ein niedrigeres Eingangssignal den Zeitpunkt nach hinten verschiebt.

Der genannte Zeitpunkt bildet das Ende des genannten Zeitraumes, dessen Anfang zum Zeitpunkt des vorherigen Vorzeichenwechsels der Spannung am ersten Zweig ist. Dabei fällt dieser Zeitpunkt zusammen mit einem Umschaltzeitpunkt des Schalters, bei einer bevorzugten Ausführungsvariante insbesondere mit dem Öffnen des Schalters, wodurch ein parallel zu dem Schalter liegender Widerstand aktiv wird und den ersten Zweig mit Masse verbindet.

Vorzugsweise wird ein Zähler gestartet, wenn das Ausgangssignal des Vergleichers seinen Wert ändert. Zudem wird der Zähler wieder gestoppt, wenn das Ausgangssignal des Vergleichers wieder auf den vorherigen Wert zurückwechselt. Der Zählerstand des Zählers repräsentiert dann die zu bestimmende Zeitspanne. Der Zähler kann hier durch den o.g. Zeitgeber realisiert sein.

Bevorzugt wird der bestimmten Zeitspanne aus einem hinterlegten mathematischen oder tabellarischen Zusammenhang eine Höhe des Eingangssignals zugeordnet. Dies kann durch den zuvor beschriebenen Zuordner erfolgen.

Um die bei einer Hysterese des Kernmaterials vorliegende Zweideutigkeit aufzulösen und somit eine ausreichende Auflösung zu erreichen, ist es von Vorteil, wenn die Messung des Zeitraums immer in dem gleichen Bereich der Hysteresekurve erfolgt, d.h. die Magnetisierungskurve nicht wiederholt durchlaufen wird. Dies kann dadurch erreicht werden, eine zyklische Vormagnetisierung durchgeführt wird, beispielsweise indem der Schalter zyklisch für einen längeren Zeitraum geschlossen wird. Dies bewirkt, dass der Kern des Transformators in eine definierte Vormagnetisierung versetzt wird.

Weitere Merkmale, Wirkungen und Vorteile der erfindungsgemäßen Schnittstelle sowie des Verfahrens werden nachfolgend anhand von Ausführungsbeispielen und der beigefügten Figuren erläutert. Es zeigen:

Fig. 1: eine elektrische Schnittstelle zur Übertragung analoger Signale nach dem Stand der Technik
Fig. 2: eine Prinzipdarstellung der elektrischen Schnittstelle gemäß der vorliegenden Erfindung
Fig. 3: ein detailliertes Ausführungsbeispiel einer Schnittstelle gemäß der Erfindung
Fig. 4: ein zeitliches Signaldiagramm
Fig. 5: eine Permeabilitätskurve

Figur 1 zeigt ein Blockschaltbild einer elektrischen Schnittstelle 2 eines Pumpenaggregats 1 mit galvanischer Trennung 6, 7, wie sie im Stand der Technik zur Übertragung analoger 0-10V Signale 3a und digitaler PWM Signale 3b verwendet und in der Beschreibungseinleitung bereits beschrieben ist.

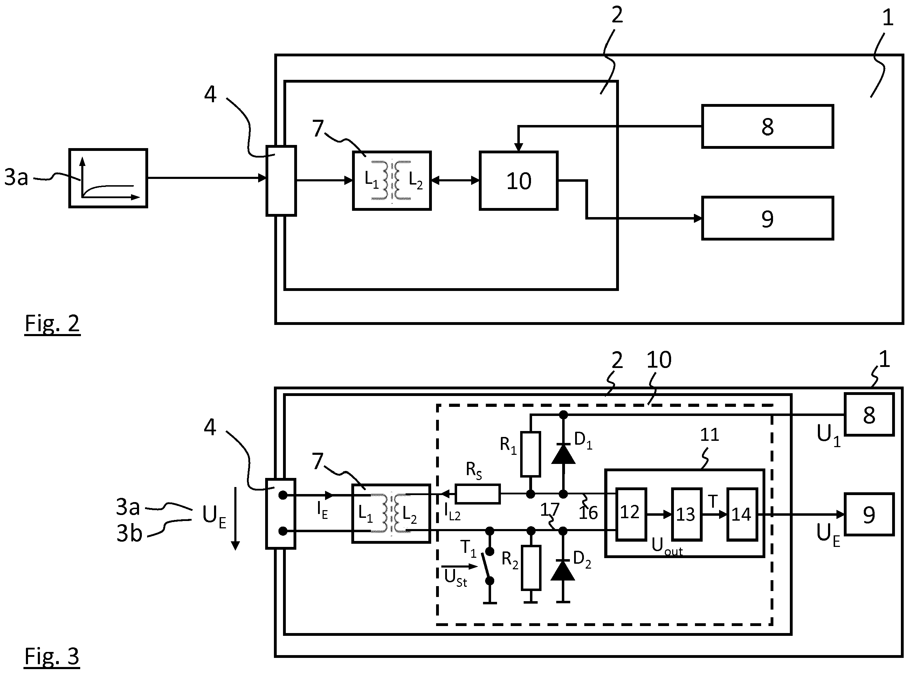

Figur 2 zeigt ein Blockschaltbild, das die Grundstruktur der erfindungsgemäßen Schnittstelle 2 mit galvanischer Trennung beschreibt. Diese galvanische Trennung erfolgt über einen Transformator 7 mit einer ersten Wicklung L1 und einer zweiten Wicklung L2, die in einem magnetischen Kreis miteinander gekoppelt sind. Beide Wicklungen L1, L2 sind hierzu gemeinsam auf einen ringförmigen Transformatorkern gewickelt. Die Schnittstelle 2 verzichtet auf eine Vorverarbeitung der analogen Eingangssignale 3a sowie auf eine weitere galvanische Trennung. Vielmehr ist die die erste Wicklung L1 direkt mit einem Schnittstelleneingang 4 verbunden, auf den das analoge Eingangssignal 3a gegeben wird, so dass das Eingangssignal 3a an der ersten Wicklung L1 anliegt. Sie bildet somit eine Eingangswicklung.

Erfindungsgemäß wird in der Schnittstelle 2 eine Messschaltung 10 vorgesehen, die mit der zweiten Wicklung L2 des Transformators 7 verbunden ist. Die zweite Wicklung L2 bildet somit eine Messwicklung. Die Messschaltung 10 wird einerseits aus einer Spannungsquelle 8 des Pumpenaggregats 1 mit Spannung versorgt. Andererseits ermittelt die Messschaltung 10 die Höhe des analogen Eingangssignals 3a und gibt diese zur Weiterleitung an eine Elektronik 9 (Motorelektronik oder Pumpenelektronik) aus.

Die Grundidee der erfindungsgemäßen Schnittstelle 2 besteht darin, den Einfluss des Eingangssignals 3a auf eine physikalische Größe des die galvanische Trennung bewirkenden Bauelements festzustellen und aus diesem Einfluss auf die Höhe des Eingangssignals zu schließen. Die Messschaltung 10 ist hierfür entsprechend eingerichtet.

Für den Fall eines Transformators 7 als galvanisch trennendes Bauelement ist die genannte physikalische Größe die Induktivität der zweiten Wicklung, die sich in Abhängigkeit der Höhe des angelegten Eingangssignals 3a mehr oder weniger ändert. Somit wird im Prinzip aus der Induktivitätsänderung auf die Höhe des Eingangssignals geschlossen. Es ist jedoch nicht erforderlich, die Induktivität selbst numerisch zu ermitteln. Vielmehr kann auch eine davon abhängige Größe oder eine mit dieser physikalisch verbundenen Größe ausgewertet werden. Dies wird nachfolgend erläutert.

Wird an die erste Wicklung L1 eine Spannung $U_E$ angelegt, so stellt sich ein Stromfluss $I_{L1}$ durch die erste Wicklung L1 ein. Dieser Stromfluss $I_{L1}$ erzeugt ein äußeres magnetisches H-Feld. Durch das äußere magnetische H-Feld entsteht ein magnetischer Fluss im Transformatorkern. Dieser magnetische Fluss wird durch das B-Feld beschrieben. Je nachdem, welches Material für den Transformatorkern verwendet wird, zieht die Erhöhung des äußeren H-Feldes eine starke oder weniger starke Erhöhung des B-Feldes nach sich. Dieser Zusammenhang wird in der Permeabilität μ beschrieben, wobei die Permeabilität μ = B/H das Verhalt des B-Feldes zum H-Feld angibt. Die Permeabilität μ ist kein konstanter Faktor, sondern besitzt aufgrund des in Sättigung gehenden Kerns (für steigende H-Werte erhöht sich das B-Feld nicht mehr) einen im Wesentlichen parabelähnlichen Verlauf.

Der Zusammenhang zwischen der Permeabilität und der Induktivität der ersten Wicklung wird durch die folgende Gleichung ausgedrückt:

$$L_1 = \mu * \frac{N_1{}^2 * A}{lm}$$

wobei $L_1$ die erste Wicklung ist, μ die Permeabilität, $N_1$ die Windungszahl der ersten Wicklung, A die Querschnittsfläche des Kerns und Im der mittlere Umfang des Kerns also die mittlere magnetische Weglänge ist. Somit weist die Induktivität eine Proportionalität zu μ auf. Daraus folgt, dass auch die Induktivität der ersten Wicklung L1 einen parabelähnlichen Verlauf bei Erhöhung des H-Feldes aufweist.

Ein Kernaspekt der Erfindung besteht darin, einen Zusammenhang zwischen der sich ändernden Induktivität der zweiten Wicklung L2, nachfolgend Messinduktivität genannt, und dem Eingangssignal bzw. dem am Schnittstelleneingang 4 eingespeisten Eingangsstrom $I_E$ zu verwenden. Hierzu sei zunächst die Formel der Feldstärke (äußeres H-feld) betrachtet, die wie folgt lautet:

$$H = \frac{N_1 * I_E}{lm}$$

wobei H die Feldstärke und $I_E$ der Eingangsstrom ist. $N_1$ entspricht der Windungszahl der ersten Wicklung L1 und *lm dem* mittleren Umfang des Transformatorkerns. Die Formel zeigt, dass sich die Feldstärke *H* proportional zum Eingangsstrom verhält. Aus $\mu$ = B/H folgt dann, dass die Permeabilität $\mu$ eine Abhängigkeit vom Eingangsstrom $I_E$ besitzt, $\mu$ = f($I_E$), und folglich auch die Induktivität $L_1$ = f($I_E$):

$$L_1 = \frac{B}{H} * \frac{N_1^2 * A}{lm} = \frac{B}{\frac{N_1 * I_E}{lm}} * \frac{N_1^2 * A}{lm} = B * \frac{N_1 * A}{I_E}$$

Da die Permeabilität $\mu$ eine Eigenschaft des Kerns ist, verursacht eine Veränderung des Permeabilitätswertes in jeder Wicklung um diesen Kern eine Induktivitätsänderung. Somit wird auch die Induktivität der zweiten Wicklung L2 verändert. Es gibt also auch eine Abhängigkeit der zweiten Wicklung L2 vom Eingangsstrom: $L_2$ = f($I_E$).

Figur 3 zeigt eine beispielhafte Ausführungsvariante der Schaltung einer erfindungsgemäßen Schnittstelle 2. Die Messschaltung 10 der Schnittstelle 2 umfasst eine Widerstandsbeschaltung, die mit der zweiten Induktivität L2 verbunden ist. Die Widerstandsbeschaltung besteht hier beispielhaft aus drei Widerständen. Ein erster Widerstand Rs liegt in Reihe mit der zweiten Wicklung L2 und wird daher als Serienwiderstand Rs bezeichnet. Serienwiederstand Rs und zweite Wicklung L2 bilden einen ersten Zweig mit einem Eingangsknoten 16 und einem Ausgangsknoten 17.

Dieser erste Zweig ist über einen zweiten Widerstand R1 zu einer Versorgungsspannung V1 verbunden, die von der Spannungsversorgung 8 des Pumpenaggregats 1 bereitgestellt wird. Der erste Zweig ist ferner über einen dritten Widerstand R2 mit Masse verbunden. Parallel zum zweiten und dritten Widerstand liegt jeweils eine Diode D1, D2. Ferner liegt parallel zum dritten Widerstand R2 ein gesteuerter Schalter T1, insbesondere ein Halbleiterschalter wie zum Beispiel ein Transistor (Bipolar oder MOSFET Transistor), der den dritten Widerstand im geschlossenen Zustand überbrück und dadurch den ersten Zweig mit Masse verbindet. Somit kann die Wirksamkeit des dritten Widerstands R2 abgeschaltet, die Widerstandsbeschaltung folglich geändert werden, indem der Schalter T1 geöffnet oder geschlossen wird. Hierzu wird eine periodische Steuerspannung $U_{st}$ in Gestalt eines Rechtecksignals verwendet, die den Schalter T1 abwechselnd auf- und zuschaltet. Die Steuerspannung $U_{st}$ kann von der Messschaltung, insbesondere einem Mikrocontroller derselben generiert werden.

Wird nun an den Schnittstelleneingang 4 ein analoges, abschnittsweise konstantes Eingangssignal $U_E$ angelegt, fließt ein entsprechender Strom $I_E$ durch die erste Wicklung und aufgrund des magnetischen Flusses im Transformatorkern wird gemäß den aufgezeigten Zusammenhängen die Permeabilität und damit die Induktivität der zweiten Wicklung L2 verändert. Kern der Erfindung ist es, aus dieser Änderung auf die Höhe des Eingangssignals zu schließen.

Dies erfolgt gemäß der in Fig. 3 dargestellten Ausführungsvariante dadurch, dass ein periodisches Steuersignal Ust an den Steuereingang des Schalters $T_1$ angelegt wird, infolge dessen der Schalter $T_1$ abwechselnd öffnet und schließt. Das Steuersignal ist vorzugsweise ein Rechtecksignal. Geeigneterweise hat das Steuersignal eine Frequenz zwischen 1kHz und 20kHz, beispielsweise 8 kHz. Das Steuersignal Ust kann beispielsweise von einem Frequenzgenerator erzeugt werden. Vorzugsweise kann ein solcher Frequenzgenerator Teil der Messschaltung 10 sein. In dem hier gewählten Beispiel ist das Steuersignal $U_{St}$ so gewählt, dass der Ein-Zustand kürzer anliegt als der Aus-Zustand des Schalters T1. Es ist ein Tastverhältnis von etwa 30% gewählt.

Durch das Schließen des Schalters T1 wird der Widerstand R2 überbrückt und der erste Zweig zu Masse hin geschaltet. Das Schließen des Schalters T1 verbindet den zweiten Zweig über den Widerstand Rs zu Masse. Dann liegen die Widerstände Rs, $R_1$, samt der zweiten Wicklung L2 in Reihe zwischen der Versorgungsspannung V1 und Masse. Der Schalter T1 ist somit in der Lage, die Widerstandsbeschaltung zu ändern.

Durch das periodische Schalten des Schalters T1 wird der dritte Widerstand $R_2$ ebenfalls periodisch in Reihe zum ersten Zweig geschaltet bzw. überbrückt. Im Ergebnis führt dies dazu, dass der zweiten Wicklung L2 abwechselnd zwei verschiedene Spannungen aufgeprägt werden können. Somit ergeben sich für den stationären Zustand jeweils zwei unterschiedliche Spannungswerte am Eingangsknoten 16 und Ausgangsknoten 17, d.h. an den Klemmen der Messinduktivität $L_1$. Dies wird nachfolgend anhand eines numerischen Beispiels gegeben.

Es wird eine Spannungsversorgung $V_1$ von beispielhaft 5V verwendet. Zudem werden der zweite und dritte Widerstand identisch R1=R2, z.B. 150 $\Omega$, und der Serienwiderstand als 1/15 von R1 bzw. R2 gewählt, d.h. 10 $\Omega$. Die Widerstandsbeschaltung bildet einen Spannungsteiler, so das sich nach der Spannungsteilerregel folgende stationäre Spannungen gegenüber Masse am Eingangsknoten 16 und Ausgangsknoten 17 ergeben:

Für $T_1$ ergibt sich im geöffneten Zustand:

$$\text{Eingangsknoten 16:} \quad U_{L2+} = \frac{R_S + R_2}{R_1 + R_S + R_2} * V_1 = 2{,}58V$$

$$\text{Ausgangsknoten 17:} \quad U_{L2-} = \frac{R_2}{R_1 + R_S + R_2} * V_1 = 2{,}42V$$

Für $T_1$ ergibt sich im geschlossenen Zustand:

$$\text{Eingangsknoten 16:} \quad U_{L2+} = \frac{R_S}{R_1 + R_S} * V_1 = 0{,}31V$$

$$\text{Ausgangsknoten 17:} \quad U_{L2-} = 0V$$

Das Erreichen des jeweiligen stationären Zustands erfolgt, abgesehen von der Spannung am Ausgangsknoten 17 beim Schließens von T1, nicht sofort, sondern jeweils durch einen exponentiellen Verlauf, entweder exponentiell ansteigend oder exponentiell abklingend. Dies ist in Fig. 4 veranschaulicht, welche ein Diagramm des zeitlichen Verlaufs der Spannungen $U_{L2+}$ und $U_{L2-}$ an der Eingangs- und der Ausgangsklemme 16, 17 des ersten Zweiges zeigt. Dieser Verlauf ist in der Lenz'schen Regel begründet: wird der magnetische Fluss in einer Spule verändert, so wird durch die Selbstinduktionsspannung ein Stromfluss erzeugt, welcher stets so gerichtet ist, dass ein Magnetfeld entsteht welches der Änderung des magnetischen Flusses entgegenwirkt.

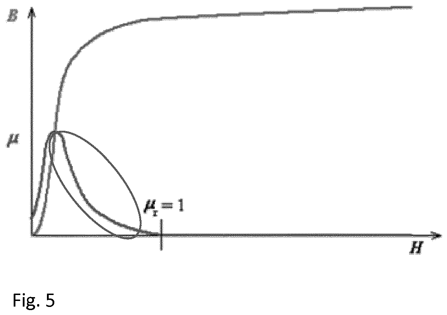

Durch das Schließen des Schalters T1 wird der Ausgangsknoten 17 auf Masse gezogen, so dass $U_{L2-}$ = 0V wird. Die Spannung an der Eingangsklemme 16 läuft exponentiell fallend gegen den stationären Wert 0,31V, der hier allerdings nicht erreicht wird, da der Schalter T1 vorher wieder geöffnet wird. Während des Fallens wirkt an der zweiten Wicklung L2 eine positive Spannung, womit sich aufgrund des integralen Zusammenhangs von Strom und Spannung an der Wicklung ($I_L$ = 1/L $\int U_L$ dt) ein ansteigender Strom $I_L$ ergibt. Dessen Verlauf ist in dem Diagramm in Figur 5 abgebildet. Da jedoch die treibende Spannung stetig fällt, steigt der Strom zunehmend weniger steil an.

Der Schalter T1 wird geöffnet, bevor die Spannung an der Eingangsklemme 16 ihren stationären Wert erreicht hat. Der dritte Widerstand R2 wird dadurch abrupt in Reihe mit dem ersten Zweig geschaltet. Aufgrund der Stetigkeit des Stroms fließt nun der zum Umschaltzeitpunkt fließende Strom (etwa 29mA) durch den dritten Widerstand R2, so dass an diesem sofort ein entsprechender Spannungsabfall entsteht (ca. 4,35V), wodurch die Spannung an der Ausgangsklemme 17 auf den Wert dieses Spannungsabfalls angehoben wird. In diesem Moment ist aber die Spannung an der Eingangsklemme 16 noch unverändert (bei ca. 0,65V), so dass die Spannung an der Ausgangsklemme 17 über der Spannung an der Eingangsklemme gestiegen ist. Somit ist die Gesamtspannung über dem ersten Zweig negativ geworden. Da die Widerstandsbeschaltung einen Spannungsteiler bildet, an dem gesamtheitlich die Versorgungsspannung V1 (5V) abfällt und derselbe Strom (etwa 29mA) durch alle Widerstände fließt, wird die an der zweiten Wicklung L2 anliegende Spannung negativ (ca. -4,35V), da diese den über die Versorgungsspannung $V_1$ hinaus gehenden Spannungsabfall der Widerstände ($U_{R1}$ = $U_{R2}$ = 4,35V, $U_{RS}$ = 0,65V; $\Sigma$ = 9,35V) kompensieren muss. Aufgrund dieser negativen, treibenden Spannung an der zweiten Wicklung L2 sinkt der Strom $I_{L2}$ exponentiell fallend, bis die Spannung an der zweiten Wicklung L2 null ist. Der Strom $I_{L2}$ bleibt dann konstant und es sind die stationären Spannungsabfälle an den Anschlussknoten 16, 17 im Wesentlichen erreicht, hier also $U_{L2+}$ = 2,58V und $U_{L2-}$ = 2,42V. Allerdings wird der stationäre Spannungswert von $U_{L2+}$ bei geschlossenem Schalter $T_1$ nicht ganz erreicht, da zuvor der Schalter $T_1$ wieder geschlossen wird. Denn ein Vorteil des erfindungsgemäßen Verfahren ist, dass das Erreichen des stationären Werts für die Auswertung nicht relevant ist.

Der Schalter $T_1$ wird dann wieder geschlossen, so dass die Spannung des Ausgangknotens 17 wieder auf Masse geht und die Spannung des Eingangsknotens 16 wieder exponentiell fallend dem stationären Wert $U_{L2+}$ = 0,31V entgegenstrebt. Zum Zeitpunkt $\tau$ nach dem Öffnen des Schalters $T_1$ schneiden sich im oberen Diagramm in Figur 4 die Verläufe der Spannungen von Eingangs- und Ausgangklemme 16, 17 des ersten Zweigs. In diesem Punkt ist dann die Spannung über dem ersten Zweig null, d.h. dass die Spannung $U_{RS}$ an dem Serienwiderstand Rs und die Spannung $U_{L_2}$ an der zweiten Wicklung $L_2$ gerade betraglich gleich groß sind, jedoch entgegengesetzte Vorzeichen haben und sich deshalb aufheben.

Der Zeitpunkt, an dem sich die Klemmenspannungen $U_{L2+}$ und $U_{L2-}$ kreuzen, ist abhängig von der Dauer bis der stationäre Zustand erreicht wird. Diese Dauer wird bei einem exponentiellen Vorgang durch die sogenannte Zeit-konstante $\tau$ mit

$$\tau = \frac{L}{R}$$

beschrieben. L ist die Induktivität der zweiten Wicklung $L_2$. R entspricht dem wirkenden Gesamtwiderstand, d.h. dem Widerstand der in Reihe zur zweiten Wicklung $L_2$ liegenden Widerstände ($R_{ges} = R_1 + R_s + R_2$). Vergrößert sich die Zeitkonstante, ändern sich die Klemmenspannungen $U_{L2+}$ und $U_{L2-}$ langsamer. Verringert sich die Zeitkonstante, ändern sich die Klemmenspannungen $U_{L2+}$ und $U_{L2-}$ schneller.

Somit lässt sich erkennen, dass der Kreuzungszeitpunkt und damit die Zeitspanne T vom Schaltzeitpunkt des Schalters $T_1$ bis zum Kreuzungszeitpunkt von der Höhe der Messinduktivität $L_2$ abhängt, da der Widerstandswert $R_{ges}$ ein konstanter Faktor ist. Es besteht also eine Proportionalität zwischen der Zeitspanne T und der Messinduktivität $L_2$. Das heißt bei Änderung der Messinduktivität $L_2$ der zweiten Wicklung entsteht eine proportionale Änderung der Zeitspanne und damit verschiebt sich der Zeitpunkt, an dem sich die Klemmenspannungen $U_{L2+}$, $U_{L2-}$ kreuzen.

Um diese Beeinflussung der Zeitkonstante $\tau$ erfassbar zu machen, wird ein Vergleicher 12 eingesetzt, der mit dem Eingangsknoten 16 und dem Ausgangsknoten 17 des ersten Zweiges verbunden ist und der die Spannungen dieser Knoten 16, 17 miteinander vergleicht. Dieser Vergleicher 12 ist hier Teil einer Signalauswerteeinheit 11. Der Vergleicher kann in einer Ausführungsvariante beispielsweise ein Komparator sein.

Wird die Spannung $U_{L2-}$ am Ausgangsknoten 17 als Referenzspannung verwendet, gibt der Komparator 12 als Ausgangssignal eine 0 (Masse) aus, wenn die Spannung $U_{L2+}$ am Eingangsknoten 16 größer ist als am Ausgangsknoten 17. Dies ist ab dem zuvor beschriebenen Kreuzungspunkt der Spannungen $U_{L2+}$ und $U_{L2-}$ sowie für den Zeitraum der Fall, in dem der Schalter T1 geschlossen ist. Öffnet der Schalter T1, so wechselt der Komparator seinen Wert am Ausgang, da nun die zu vergleichende Spannung $U_{L2+}$ höher als die referenzierte Spannung $U_{L2-}$ ist. Somit ist das Ausgangssignal Uout des Komparators nur während der Zeitspanne T null, anderenfalls positiv, hier logisch 1, z.B. in Höhe der Versorgungsspannung V1 (5V). Das Ausgangssignal des Komparators 12 ist in Fig. 4.

Alternativ zu einem Komparator kann auch ein Vergleicher verwendet werden, der ein positives Ausgangssignal Uout liefert, z.B. logisch 1 (5V), wenn $U_{L2+} > U_{L2-}$ ist und ein negatives Ausgangssignal liefert, z.B. logisch -1 (-5V), wenn $U_{L2+} <= U_{L2-}$ ist. Dies entspricht der Art eines Differenzierers. Wiederum alternativ kann auch ein Vergleicher verwendet werden, der ein Ausgangssignal Uout größer als 1 liefert (z.B. > 1V), wenn $U_{L2+} > U_{L2-}$ ist und ein Ausgangssignal kleiner als 1 liefert (z.B. < 1V), wenn $U_{L2+} <= U_{L2-}$ ist. Dies entspricht der Art eines Dividierers. Die dargestellten Zusammenhänge können jedoch auch andersherum sein. Gleiches gilt für den Komparator. So kann beispielsweise auch die Spannung $U_{L2+}$ am Eingangsknoten 17 als Referenzspannung verwendet werden.

Aus dem Verlauf des Ausgangssignals Uout des Vergleichers 12 wird deutlich, dass eine fallende Flanke dann auftritt, wenn der Schalter T1 geöffnet wird, d.h. die Spannung an der zweiten Wicklung L2 negativ wird, und dass eine steigende Flanke auftritt, wenn sich die beiden Spannungen $U_{L2-}$ und $U_{L2+}$ am Eingangsknoten 16 und Ausgangsknoten 17 kreuzen.

Da, wie zuvor beschrieben, der Zeitpunkt für dieses Kreuzen abhängig von der Zeitkonstante $\tau$ des Verlaufs, folglich auch abhängig von der Induktivität ist, wird durch eine Änderung der Induktivität der zweiten Wicklung $L_2$ infolge des Eingangssignals $U_E$ auch der Zeitpunkt der positiven Schaltflanke des Vergleichers beeinflusst, insbesondere nach links verschoben, wenn sich die Induktivität verringert, und nach rechts verschoben, wenn sie sich vergrößert. Folglich wird die Pulsbreite des Komparatorausgangssignals Uout vergrößert oder verkleinert.

Da von der Messschaltung 10 ein Stromfluss durch die Messwicklung $L_2$ erzeugt wird, erzeugt das dadurch entstehende H-Feld einen magnetischen Fluss im Kern des Transformators. Und da dieses H-Feld, und damit auch der Fluss im Kern, stets vorhanden ist, quasi einen Grundfluss bildet, und das von der ersten Wicklung L1 erzeugte H-Feld bzw. der Fluss im Kern null werden kann (Eingangssignal $U_E$ = 0V), ist es von Vorteil, wenn der Wicklungssinn der beiden Wicklungen so gewählt wird, dass bei bestimmungsgemäßer Beaufschlagung des Schnittstelleneingangs 4 mit dem Eingangssignal $U_E$, d.h. korrekter Polung, der im Kern jeweils erzeugte Fluss in die gleiche Richtung gerichtet ist. Somit ist gewährleistet, dass sich die von der Eingangswicklung L1 und der Messwicklung L2 jeweils erzeugten magnetischen Flüsse positiv addieren. Mit anderen Worten wird verhindert, dass der Grundfluss durch den seitens der Eingangswicklung erzeugten Fluss verringert oder bei betraglich höherem Wert als seitens der Messwicklung sogar negativ sein kann, womit die Permeabilität nicht mehr eindeutig wäre, da sie sowohl für B > 0 und H > 0 als auch für B < 0 und H < 0 jeweils positiv ist.

Aufgrund dessen, dass die Flüsse sich addieren (Verlauf von B befindet sich folglich nur im 1. Quadranten) wird ausschließlich der abfallende Verlauf der Permeabilitätskurve (Darstellung der Permeabilität $\mu$ über der Feldstärke H) für die Messung verwendet (siehe Markierung in Figur 5). Das bedeutet, dass die Messschaltung 10 eingerichtet ist, die zweite Wicklung derart mit einer Spannung zu beaufschlagen, dass sie einen Grundfluss erzeugt wird, die etwa gleich derjenigen Feldstärke ist, bei der die Permeabilität maximal ist $\mu = \mu_{max}$. Dieser höchste Punkt der Permeabilität $\mu_{max}$ wird als Ausgangspunkt verwendet. Das bedeutet, dass er für ein Eingangssignal $U_E$ null gilt. Denn mit einem Eingangssignal größer null, erhöht sich die Feldstärke an der zweiten Wicklung und die Permeabilität sinkt gemäß der Kurve in Fig. 5. Somit wird erfindungsgemäß ein Bereich der Permeabilitätskurve ausgenutzt, in dem die Permeabilität $\mu$ annähernd linear und monoton von der Feldstärke H abhängt.

Gemäß Figur 3 umfasst die Signalauswertung 11 einen Zeitgeber 13. Der Zeitgeber 13 ist dafür vorgesehen, eine für den zeitlichen Verlauf zumindest einer elektrischen Größe der Widerstandsbeschaltung charakteristische Zeitspanne T in der Art einer Stoppuhr oder eines Zählers zu bestimmen. Anders betrachtet, kann der Zeitgeber auch als Integrator verstanden werden, der linear aufsummiert. In dem vorliegenden Beispiel ist es die vom Öffnungszeitpunkt des Schalters T1 bis zum Zeitpunkt, an dem sich die Spannungen am Eingangs- und Ausgangsknoten 16, 17 schneiden, vergehende Zeitspanne T, siehe Fig. 4. Hierzu ist dem Zeitgeber 13 das Ausgangssignal Uout des Vergleichers 12 zugeführt, so dass er von diesem angesteuert ist.

Wechselt das Ausgangssignal Uout auf Masse (fallende Flanke), wird der Zeitgeber 13 bei null gestartet und zählt in einer vorbestimmten Schrittweite pro Sekunde hoch. Dies erfolgt solange, bis das Ausgangssignal Uout wieder auf einen Wert von logisch 1 ($V_1$) zurückwechselt (steigende Flanke). In diesem Fall wird der Zeitgeber gestoppt. Der dann erreichte Zählerstand repräsentiert die Zeitspanne und ist damit charakteristisch für den zeitlichen Verlauf der elektrischen Größen der Widerstandsbeschaltung und insbesondere charakteristisch für den Wert des Eingangssignals $U_E$, da dieses Eingangssignal $U_E$ die Zeitspanne beeinflusst.

Im Ergebnis wird durch die Bestimmung der Zeitspanne die Stromanstiegsgeschwindigkeit in der zweiten Wicklung gemessen.

Dem Zeitgeber 13 nachgeschaltet, ist ein Zuordner 14, welchem die ermittelte Zeitspanne T zugeführt ist und der der Zeitspanne T einen Wert des Eingangssignals $U_E$ zuordnet. Dies kann im Rahmen der Auswertung eines funktionalen Zusammenhangs $U_E= f(T)$ oder im Rahmen einer tabellarischen Zuordnung erfolgen, die im Zuordner 14 hinterlegt sein kann. Der Zusammenhang zwischen der Zeitspanne T und dem Eingangssignal $U_E$ ist werksseitig ermittelt worden und in der Signalauswertung 11 abgespeichert. Der Zuordner 14 gibt an seinem Ausgang einen dem Wert des Eingangssignals $U_E$ entsprechenden Wert aus, welcher der Elektronik 9 zur weiteren Verarbeitung zugeleitet wird.

Auf diese Weise wird ein abschnittsweise konstantes analoges Spannungssignal wie z.B. ein 0-10V Spannungssignal vom Schnittstelleneingang 4 galvanisch getrennt zur Elektronik 9 übertragen. Über denselben Schnittstelleneingang oder einen dazu parallel liegenden Eingang kann auch ein abschnittsweise konstantes analoges Stromsignal wie z.B. ein 4-20mA Stromsignal auf die erfindungsgemäße Weise und über die erfindungsgemäße Schnittstelle 2 übertragen werden, indem ein Widerstand, z.B. in Höhe von 500 Ohm parallel zu den beiden Eingangsklemmen des Schnittstelleneingangs 4 geschaltet wird. Dies kann beispielsweise manuell über einen Dip-Schalter oder durch elektronische Zuschaltung erfolgen. Der Widerstand wandelt das Stromsignal in ein proportionales Spannungssignal, welches wie zuvor beschrieben durch die Schnittstelle übertragen wird.

Von besonderem Vorteil ist ferner, dass über denselben Schnittstelleneingang, oder einen dazu parallel liegenden Eingang auch ein digitales Signal wie ein PWM Signal als Eingangssignal $U_E$ übertragen werden kann.

Die Signalauswerteeinheit 11 kann durch einen Mikrocontroller gebildet sein, in dem der Vergleicher 12, der Zeitgeber 13 und / oder der Zuordner 14 jeweils eine eigenständige Funktionseinheit bilden. Alternativ können der Vergleicher 12, der Zeitgeber 13 und / oder der Zuordner 14 als diskrete Bauelemente ausgebildet sein und lediglich hinsichtlich ihrer Gesamtfunktionalität die Signalauswerteeinheit bilden.

**Patentansprüche**

1. Elektrische Schnittstelle (2) eines Pumpenaggregats (1) zur galvanisch getrennten Übertragung eines analogen Eingangssignals zu einer Elektronik (9), umfassend einen Transformator (7) mit einer ersten (L1) und einer in einem magnetischen Kreis mit der ersten (L1) gekoppelten zweiten (L2) Wicklung, **dadurch gekennzeichnet, dass** die erste Wicklung (L1) mit einem Schnittstelleneingang (4) zum Anlegen des Eingangssignals und die zweite Wicklung (L2) mit einer änderbaren Widerstandsbeschaltung einer Messschaltung (10) verbunden ist, die dazu eingerichtet ist, die zweite Wicklung (L2) durch die Änderung der Widerstandsbeschaltung mit einer wechselnden Spannung zu beaufschlagen, aus dem zeitlichen Verlauf zumindest einer elektrischen Größe der Widerstandsbeschaltung eine Zeitspanne zu bestimmen und daraus die Höhe des Eingangssignals zu ermitteln.

2. Elektrische Schnittstelle (2) nach Anspruch 1, **dadurch gekennzeichnet, dass** die Widerstandsbeschaltung einen Spannungsteiler bildet und die zweite Wicklung (L2) in einem ersten Zweig dieses Spannungsteilers, insbesondere in diesem Zweig in Reihe mit einem Serienwiderstand (Rs) liegt.

3. Elektrische Schnittstelle (2) nach Anspruch 2, **dadurch gekennzeichnet, dass** zur Erzeugung der wechselnden Spannung der elektrisch wirksame Widerstand eines Zweiges des Spannungsteilers änderbar ist.

4. Elektrische Schnittstelle (2) nach einem der vorherigen Ansprüche, **dadurch gekennzeichnet, dass** die Widerstandsbeschaltung zumindest drei Widerstände (R1, Rs, R2) umfasst, und die zweite Wicklung (L2) wahlweise mit zwei oder drei der Widerstände (R1, Rs, R2) in Reihe zwischen eine Versorgungsspannung (V1) und Masse schaltbar ist.

5. Elektrische Schnittstelle (2) nach einem der vorherigen Ansprüche, **dadurch gekennzeichnet, dass** die Widerstandsbeschaltung einen steuerbaren Schalter (T1) insbesondere einen steuerbaren Halbleiterschalter aufweist, um die Widerstandsbeschaltung zu ändern, der parallel oder in Reihe mit einem Widerstand (R2) der Widerstandsbeschaltung liegt.

6. Elektrische Schnittstelle (2) nach Anspruch 5, **dadurch gekennzeichnet, dass** die Messschaltung (10) eingerichtet ist, den Schalter (T1) periodisch ein und aus zu schalten, insbesondere mit einer Frequenz zwischen 1kHz und 20kHz.

7. Elektrische Schnittstelle (2) zumindest nach Anspruch 2, **dadurch gekennzeichnet, dass** die Messschaltung (9) eine Signalauswerteeinheit (11) parallel zu dem ersten Zweig umfasst, wobei die zumindest eine elektrische Größe die an dem Zweig anliegende Spannung ist.

8. Elektrische Schnittstelle (2) nach Anspruch 7, **dadurch gekennzeichnet, dass** die Signalauswerteeinheit (11) einen Vergleicher (12) zum Vergleichen des Potenzials am Eingangsknoten (16) des ersten Zweiges mit dem Potential am Ausgangsknoten (17) des ersten Zweiges umfasst, insbesondere, dass der Vergleicher (12) ein Komparator ist.

9. Elektrische Schnittstelle (2) nach Anspruch 8, **dadurch gekennzeichnet, dass** die Signalauswerteeinheit (11) einen Zeitgeber (13) umfasst, der dazu eingerichtet ist, bei einem ersten Wechsel des Ausgangssignals des Vergleichers (12) einen Zähler zu starten und bei einem zweiten Wechsel des Ausgangssignals des Vergleichers den Zähler zu stoppen, wobei der Zählerwert die abgeleitete Zeitspanne beschreibt.

10. Elektrische Schnittstelle (2) nach Anspruch 7, 8 oder 9, **dadurch gekennzeichnet, dass** die Signalauswerteeinheit (11) einen Zuordner (14) umfasst, der dazu eingerichtet ist, aus der abgeleiteten Zeitspanne die Höhe des Eingangssignals ($U_E$) zu ermitteln.

11. Verfahren zur galvanisch getrennten Übertragung eines analogen Eingangssignals über eine Schnittstelle (2) zu einer Elektronik (9), wobei die Schnittstelle (7) einen Transformator (7) mit einer ersten (L1) und einer in einem magnetischen Kreis mit der ersten (L1) gekoppelten zweiten (L2) Wicklung aufweist, **gekennzeichnet durch** die folgenden Schritte

   - Beaufschlagung der ersten Wicklung (L1) mit dem Eingangssignal
   - Beaufschlagen der zweiten Wicklung (L2) mit einer wechselnden Spannung durch Ändern einer Widerstandsbeschaltung einer Messschaltung (10), die mit der zweiten Wicklung (L2) verbunden ist,
   - Bestimmung einer Zeitspanne (T) aus dem zeitlichen Verlauf zumindest einer elektrischen Größe der Widerstandsbeschaltung, und
   - Ermittlung der Höhe des Eingangssignals aus der Zeitspanne (T).

12. Verfahren nach Anspruch 11, **dadurch gekennzeichnet, dass** die wechselnde elektrische Spannung dadurch erzeugt wird, dass die zweite Wicklung (L2) abwechselnd mit zwei oder drei Widerständen (R1, Rs, R2) zwischen eine Versorgungsspannung (V1) und Masse geschaltet wird.

13. Verfahren nach Anspruch 11 oder 12, **dadurch gekennzeichnet, dass** die Bestimmung der Zeitspanne (T) aus der Spannung an einem ersten Zweig der Widerstandsbeschaltung erfolgt, der die zweite Wicklung (L2) oder eine Reihenschaltung aus der zweiten Wicklung (L2) und einem Serienwiderstand (Rs) umfasst.

14. Verfahren nach Anspruch 13, **dadurch gekennzeichnet, dass** die Ableitung mittels eines Vergleichers (12) insbesondere eines Komparators erfolgt, der parallel zu dem ersten Zweig liegt und dessen Ausgangssignal wechselt, wenn die Spannung am ersten Zweig ihr Vorzeichen wechselt.

15. Verfahren nach Anspruch 14, **dadurch gekennzeichnet, dass** ein Zähler gestartet wird, wenn das Ausgangssignal des Vergleichers (12) seinen Wert ändert und der Zähler wieder gestoppt wird, wenn das Ausgangssignal (Uout) des Vergleichers (12) wieder auf den vorherigen Wert zurückwechselt, wobei der Zählerstand des Zählers die Zeitspanne (T) repräsentiert.

**Claims**

1. Electrical interface (2) of a pump unit (1) for the galvanically isolated transmission of an analogue input signal to an electronics unit (9), comprising a transformer (7) with a first (L1) and a second coil (L2) coupled in a magnetic circuit with the first coil (L1), **characterised by** the first coil (L1) being connected to an interface input (4) for application of the input signal and the second coil (L2) being connected to a variable resistor circuitry of a measuring circuit (10), which is configured to apply a changing voltage to the second coil (L2) through the change of the resistor circuitry and to determine a time period from the chronological sequence of at least one electrical parameter of the resistor circuitry, and to determine the level of the input signal from this.

2. Electrical interface (2) according to claim 1, **characterised by** the resistor circuitry forming a voltage divider and the second coil (L2) lying in a first branch of this voltage divider, in particular in series with a series resistance (Rs) within this branch.

3. Electrical interface (2) according to claim 2, **characterised by** the electrically effective resistance of a branch of the voltage divider being changeable in order to generate the changing voltage.

4. Electrical interface (2) according to one of the preceding claims, **characterised by** the resistor circuitry comprising at least three resistors (R1, Rs, R2) and the second coil (L2) being switchable with a choice of two or three resistors (R1, Rs, R2) in series between a supply voltage (V1) and earth.

5. Electrical interface (2) according to one of the preceding claims, **characterised by** the resistor circuitry having a controllable switch (T1), in particular a controllable semiconductor switch, in order to change the resistor circuitry, which lies parallel to or in series with a resistor (R2) of the resistor circuitry.

6. Electrical interface (2) according to claim 5, **characterised by** the measuring circuit (10) being configured to turn the switch (T1) on and off periodically, in particular with a frequency between 1kHz and 20kHz.

7. Electrical interface (2) according to at least claim 2, **characterised by** the measuring circuit (9) comprising a signal evaluation unit (11) parallel to the first branch, in which at least one electrical parameter is the voltage applied to the branch.

8. Electrical interface (2) according to claim 7, **characterised by** the signal evaluation unit (11) comprising a comparing element (12) to compare the potential at the input node (16) of the first branch to the potential at the output node (17) of the first branch, in particular with the comparing element (12) being a comparator.

9. Electrical interface (2) according to claim 8, **characterised by** the signal evaluation unit (11) comprising a timer (13) that is set up to start a counter the first time the output signal of the comparing element (12) changes and to stop the counter the second time the output signal of the comparing element changes, in which the counter value describes the derived time period.

10. Electrical interface (2) according to claim 7, 8 or 9, **characterised by** the signal evaluation unit (11) comprising a sequencer (14) that is configured to determine the level of the input signal ($U_E$) from the derived time period.

11. Procedure for the galvanically isolated transmission of an analogue input signal via an interface (2) to an electronics unit (9), in which the interface (7) has a transformer (7) with a first (L1) and a second (L2) coil coupled with the first coil (L1) in a magnetic circuit, **characterised by** the following steps:

   - Application of the input signal to the first coil (L1),

- application of a changing voltage to the second coil (L2) by changing a resistor circuitry of a measuring circuit (10) that is connected to the second coil (L2),
- determination of a time period (T) from the chronological sequence of at least one electrical parameter of the resistor circuitry, and
- determination of the level of the input signal from the time period (T).

12. Procedure according to claim 11, **characterised by** the changing electrical voltage being generated by the second coil (L2) with two or three resistors (R1, Rs, R2) being alternately switched between a supply voltage (V1) and earth.

13. Procedure according to claim 11 or 12, **characterised by** the time period (T) being determined from the voltage on a first branch of the resistor circuitry, comprising the second coil (L2) or a series connection of the second coil (L2) and a series resistance (Rs).

14. Procedure according to claim 13, **characterised by** the derivation being realised by means of a comparing element (12), in particular a comparator, which lies parallel to the first branch and generates an output signal that changes when the voltage on the first branch changes its leading sign.

15. Procedure according to claim 14, **characterised by** a counter being started when the output signal of the comparing element (12) changes its value and the counter being stopped again when the output signal (Uout) of the comparing element (12) changes back to its previous value, in which the counter reading of the counter represents the time period (T).

### Revendications

1. Interface électrique (2) d'une unité de pompage (1) pour la transmission isolée galvaniquement d'un signal d'entrée analogique vers un système électronique (9), comprenant un transformateur (7) avec un bobinage (L1) relié à un second bobinage (L2) intégré à un circuit magnétique, **caractérisée en ce que** le premier bobinage (L1) est relié à une entrée d'interface (4) destinée à créer le signal d'entrée et le second bobinage (L2) est relié au circuit à résistances variable d'un circuit de mesure (10), lequel est configuré pour appliquer une tension alternative au second bobinage (L2) en modifiant le circuit à résistances, sachant que l'évolution temporelle d'au moins une grandeur électrique du circuit à résistances permet de déterminer une période et ainsi de transmettre la valeur du signal d'entrée.

2. Interface électrique (2) selon la revendication 1, **caractérisée en ce que** le circuit à résistances crée un diviseur de tension et que le second bobinage (L2) est placé dans une branche de ce diviseur de tension, où il est plus particulièrement connecté en série avec une résistance en série (Rs).

3. Interface électrique (2) selon la revendication 2, **caractérisée en ce que,** pour la génération de la tension alternative, la résistance électriquement efficace d'une branche du diviseur de tension est variable.

4. Interface électrique (2) selon l'une des revendications précédentes, **caractérisée en ce que** le circuit à résistances comprend au moins trois résistances (R1, Rs, R2), le second bobinage (L2) pouvant, entre une tension d'alimentation (V1) et la masse, être connecté en série au choix à deux ou trois des résistances (R1, Rs, R2).

5. Interface électrique (2) selon l'une des revendications précédentes, **caractérisée en ce que** le circuit à résistances présente un commutateur commandable (T1), particulièrement un commutateur à semi-conducteur, permettant de modifier le circuit à résistances et relié en parallèle ou en série à une résistance (R2) du circuit à résistances.

6. Interface électrique (2) selon la revendication 5, **caractérisée en ce que** le circuit de mesure (10) est configuré pour activer et désactiver périodiquement le commutateur (T1), en particulier à une fréquence entre 1 kHz et 20 kHz.

7. Interface électrique (2) au moins selon la revendication 2, **caractérisés en ce que** le circuit de mesure (9) comprend un module d'analyse de signal (11) en parallèle par rapport à la première branche, sachant qu'au moins une grandeur électrique est la tension de la branche.

8. Interface électrique (2) selon la revendication 7, **caractérisée en ce que** le module d'analyse de signal (11) comprend un comparateur (12) destiné à comparer le potentiel au nœud d'entrée (16) de la première branche au potentiel du nœud de sortie (17) de la première branche.

9. Interface électrique (2) selon la revendication 8, **caractérisée en ce que** le module d'analyse de signal (11) comprend un minuteur (13), configuré pour, au moment d'une première alternance du signal de sortie du comparateur (12), démarrer un compteur et, au moment d'une seconde alternance du signal de sortie du comparateur, arrêter le compteur, sachant que la valeur du compteur décrit la période écoulée.

10. Interface électrique (2) selon les revendications 7, 8 ou 9, **caractérisée en ce que** le module d'analyse de signal (11) comprend un attributeur (14) configuré pour déterminer à partir de la période écoulée la valeur du signal d'entrée $(U_E)$.

11. Procédé de transmission séparée galvaniquement d'un signal d'entrée analogique au travers d'une interface (2) à un circuit électronique (9), sachant que l'interface (7) présente un transformateur (7) avec un bobinage (L1) relié à un second bobinage (L2) intégré à un circuit magnétique, **caractérisé par** les étapes suivantes :

   - Soumission d'un signal d'entrée au premier bobinage (L1),
   - Application sur le second bobinage (L2) d'une tension alternative par modification du circuit à résistances d'un circuit de mesure (10) relié au second bobinage (L2),
   - Calcul d'une période (T) à partir de l'évolution temporelle d'au moins une grandeur électrique du circuit à résistances et
   - Détermination de la valeur du signal d'entrée à partir de la période (T).

12. Procédé selon la revendication 11, **caractérisé en ce que** la tension électrique alternative est générée par le fait que le second bobinage (L2) est alternativement connecté avec deux ou trois résistances (R1, Rs, R2) entre une tension d'alimentation (V1) et la masse.

13. Procédé selon les revendications 11 ou 12, **caractérisé en ce que** la détermination de la période (T) à partir de la tension se fait sur une première branche du circuit à résistances comprenant le second bobinage (L2) ou un circuit en série composé du bobinage (L2) et d'une résistance en série (Rs).

14. Procédé selon la revendication 13, **caractérisé en ce que** la détermination est le fait d'un comparateur (12) connecté en parallèle à la première branche dont le signal de sortie change en fonction du changement de signe de la tension sur la première branche.

15. Procédé selon la revendication 14, **caractérisé en ce qu'un** compteur est démarré lorsque le signal de sortie du comparateur (12) modifie sa valeur et que le compteur est arrêté lorsque le signal de sortie (Uout) du comparateur (12) retourne à sa valeur initiale, sachant que la valeur du compteur représente la période (T) écoulée.

Fig. 1

Fig. 2

Fig. 3

Fig. 4

Fig. 5

**IN DER BESCHREIBUNG AUFGEFÜHRTE DOKUMENTE**

**In der Beschreibung aufgeführte Patentdokumente**

- DE 102005007378